# EUROPÄISCHE PATENTSCHRIFT

(11) **EP 0 429 896 B1**
(45) Veröffentlichungstag und Bekanntmachung des Hinweises auf die Patenterteilung: **10.05.1995**
(21) Anmeldenummer: 90121184.7
(22) Anmeldetag: 06.11.1990
(51) Int. Cl.: H03B 5/24, H03H 11/12

(54) **Abstimmbarer Resonanzverstärker oder Oszillator**
Tunable resonance amplifier or oscillator
Amplificateur à résonance ou oscillateur accordable

(30) Priorität: 23.11.1989 DE 3938760
(43) Veröffentlichungstag der Anmeldung: 05.06.1991
(73) Patentinhaber: TEMIC TELEFUNKEN microelectronic GmbH, 74072 Heilbronn (DE)
(72) Erfinder: Böhme, Rolf, Dr., W-7107 Bad Friedrichshall (DE)
(74) Vertreter: Maute, Hans-Jürgen, Dipl.-Ing.

(56) Entgegenhaltungen:
- EP-A- 0 393 717
- FR-A- 2 437 735
- FR-A- 2 523 783
- US-A- 4 760 353

## Beschreibung

Die Erfindung betrifft eine Schaltungsanordnung für einen abstimmbaren Resonanzverstärker oder Oszillator, die für Filterschaltungen oder zur Schwingungserzeugung verwendet werden kann. Sie ist durch großen Abstimmbereich und Integrierbarkeit gekennzeichnet.

Aus der US 4 760 353 ist ein als Oszillator verwendbarer integrierbarer Gyrator bekannt, der aus zwei hintereinandergeschalteten OTA-Verstärkern (Operational Transconductance Amplifier) aufgebaut ist. Diese OTA-Verstärker sind jeweils aus einer aus zwei bipolaren Transistoren bestehenden Differenzstufe aufgebaut, wobei beide Differenzstufen von einer Stromquelle gespeist werden. Eine zweite Stromquelle führt einen Speisestrom über jeweils einen als Diode verschalteten Transistor an jeden Eingang der beiden Differenzstufen.

An einem der beiden Ausgänge beider Differenzstufen ist jeweils ein Kondensator gegen einen Massepunkt der Schaltung geschaltet. An die gleichen Ausgänge ist jeweils eine Stromquelle angeschlossen, die von der ersten Stromquelle gesteuert wird.

Der mit dem Kondensator beschaltete Ausgang der ersten Differenzstufe ist einerseits über ein Netzwerk von Transistoren und Widerständen auf dessen nichtinvertierenden Eingang rückgekoppelt und andererseits über ein der zweiten Differenzstufe zugeordnetes weiteres Netzwerk aus Transistoren und Widerständen sowie über einen Puffertransistor mit dem nichtinvertierenden Eingang der zweiten Differenzstufe verbunden.

Ferner ist der mit dem Kondensator beschaltete Ausgang der zweiten Differenzstufe über das dieser Differenzstufe zugeordnete Netzwerk sowie über einen weiteren Puffertransistor mit dem invertierenden Eingang der ersten Differenzstufe verbunden.

Diese bekannte Oszillatorschaltung zeigt eine aufwendige Beschaltung, wobei zusätzlich der Nachteil vorliegt, daß die erste Stromquelle nicht mit der Oszillatorschaltung integrierbar ist.

Aus der EP-A-393 717, welche Stand der Technik gemäß Artikel 54(3), EPÜ, darstellt, ist eine aktive Filterschaltung, aufgebaut mit zwei Differenzstufen, bekannt. Diese Differenzstufen umfassen jeweils zwei bipolare Transistoren und werden von einer steuerbaren Stromquelle gespeist. An jeweils einem der Ausgänge der Differenzstufen ist ein Kondensator angeschlossen.

Diese bekannte Filterschaltung weist zwei negative Rückkopplungszweige auf, nämlich von dem mit dem Kondensator beschaltete Kollektoranschluß zu dem Basisanschluß des gleichen Transistors der ersten Differenzstufe und von dem mit dem anderen Kondensator beschaltete Kollektoranschluß des Transistors der zweiten Differenzstufe zu dem Basisanschluß des anderen Transistors der ersten Differenzstufe.

Ferner sind die mit den Kondensatoren beschalteten Ausgänge der Differenzstufen mit jeweils einer Stromspiegelschaltung verbunden, die ihrerseits von der steuerbaren Stromquelle gespeist werden. Mit Hilfe der dieser Stromquelle zuführbahren Steuerspannung läßt sich die Filtercharakteristik einstellen.

Die Schaltungsanordnungen in den beiden vorhin genannten Dokumenten umfassen die in Anspruch 1 definierten Merkmale a) und b).

In der DE-A- 33 09 897 wurde eine Anordnung angegeben, bei der zwei spannungsgesteuerte Stromquellen am Ausgang mit Kapazitäten beschaltet und zu einer geschlossenen Schleife verbunden sind. Durch Steuerung der Steilheit der spannungsgesteuerten Stromquellen wird die Resonanzfrequenz der Anordnung steuerbar. Dabei besteht die spannungsgesteuerte Stromquelle aus einem Spannungs-Stromwandler, einer Multiplizierstufe und einer Ausgangsstufe, was einen verhältnismäßig hohen Aufwand an Schaltelementen bedeutet. Phasenfehler jeder Stufe können in der Summe zu kritischen Gesamtfehlern führen. Der Umfang der möglichen Frequenzvariation ist begrenzt, weil die Schaltungsteile mit veränderlichem Arbeitsstrom die Schaltungsteile mit festem Arbeitsstrom nicht unzulässig belasten dürfen und umgekehrt. Die am Ausgang der gesteuerten Stromquellen angeschlossenen Kapazitäten sind gegen Masse geschaltet, der Stromkreis schließt sich über die Versorgungsspannung. Dies kann in einer Schaltung mit mehreren Funktionseinheiten zu Verkopplungen und unvorhersehbaren Effekten führen.

Der Erfindung liegt die Aufgabe zugrunde, eine Schaltungsanordnung für einen abstimmbaren Resonanzverstärker oder Oszillator mit kleinerem Schaltungsumfang, einem großen Abstimmbereich, minimalen Phasenfehlern und die eine Entlastung der Versorgungsspannung von Wechselströmen zuläßt, anzugeben. Diese Aufgabe wird durch eine Schaltungsanordnung mit den Merkmalen des Anspruchs 1 gelöst.

Die Erfindung wird im folgenden an Ausführungsbeispielen erläutert. In der zugehörigen Zeichnung zeigen:
- Figur 1: eine erste Ausführungsform der Erfindung,
- Figur 2: eine Oszillatorschaltung mit Anfachung und Signalauskopplung,
- Figur 3: eine Bandpaß-Schaltung,
- Figur 4: eine Tiefpaß-Schaltung,
- Figur 5: eine Bandsperrenschaltung.

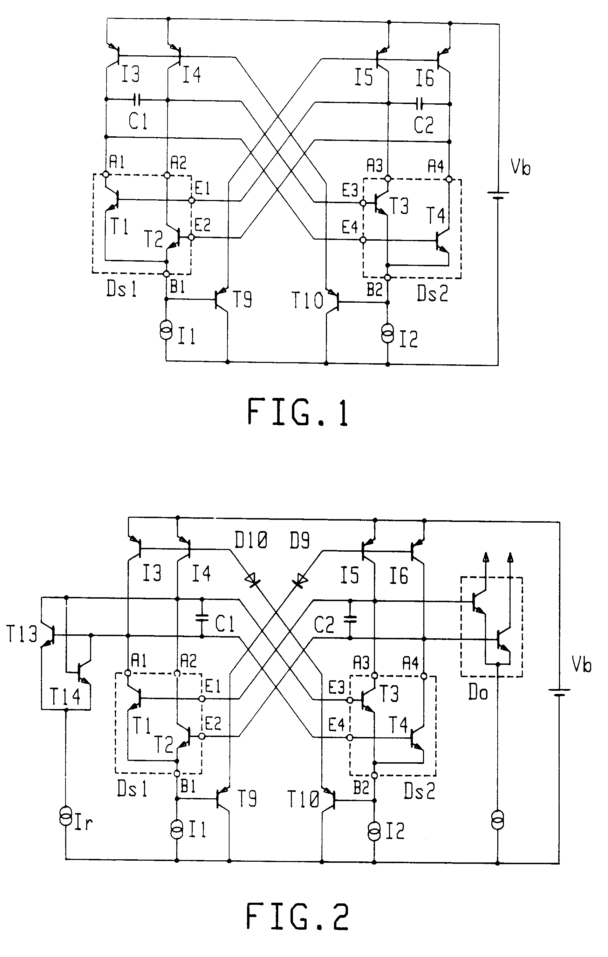

Die Schaltung nach Figur 1 besteht aus zwei Differenzstufen Ds1, Ds2, die von je einer Stromquelle I1, I2 gespeist werden. Der Ausgang A1, A2 der ersten Differenzstufe Ds1 ist mit einem Kondensator C1 abgeschlossen und mit dem Eingang E4, E3 der zweiten Differenzstufe Ds2 verbunden. Der Ausgang A3, A4 der zweiten Differenzstufe Ds2 ist mit einem Kondensator C2 abgeschlossen und mit dem Eingang E1, E2 der ersten Differenzstufe Ds1 verbunden. In der Abfolge der Verbindungen sind die Eingangsanschlüsse E3, E4 der zweiten Differenzstufe Ds2 gegenüber den Eingangsanschlüssen E1, E2 der ersten Differenzstufe Ds1 vertauscht. Außerdem sind die Ausgangsanschlüsse A1, A2 bzw. A3, A4 des ersten bzw. zweiten Differenzverstärkers Ds1 bzw. Ds2 mit je einem Paar weiterer Stromquellen I3, I4 bzw. I5, I6 verbunden. Die Eingänge der fünften und sechsten Stromquelle I5, I6 sind über ein erstes Koppelglied T9 mit dem Einspeisepunkt B1 der ersten Stromquelle I1 verbunden. Die Eingänge der dritten und vierten Stromquelle I3, I4 sind über ein zweites Koppelglied T10 mit dem Einspeisepunkt B2 der zweiten Stromquelle I2 verbunden.

Unter der Annahme, daß die Eingänge E1, E2 stromlos sind, verteilt die Differenzstufe Ds1 den von der Stromquelle I1 gelieferten Strom auf die beiden Ausgangsanschlüsse A1, A2. Wenn, wie in Figur 1 dargestellt, die Transistoren T1, T2 der Differenzstufe Ds1 bipolare Transistoren sind, gilt dies zumindest näherungsweise. Die die Ausgangsanschlüsse A1, A2 durchfließenden Ströme werden von den Stromquellen I3, I4 zur Versorgungsspannung Vb weitergeführt, wobei für die Größe der Ströme I3 = I4 = I1/2 gilt. Dies wird durch das Koppelglied T10 erreicht. Es besteht im Beispiel der Figur 1 aus einem bipolaren Transistor T10. Das Potential der Ausgange A1, A2 steuert über die Transistoren T3, T4 der zweiten Differenzstufe Ds2 das Potential am Einspeisepunkt der Stromquelle I2. Dieses Potential wird der Basis des Transistors T10 zugeführt und nach Addition seiner Emitter-Basis-Spannung an die Steuereingänge der Stromquellen I3, I4 weitergegeben. Dadurch entsteht ein Regelkreis, der die Arbeitspotentiale festlegt und verhindert, daß weder die Transistoren T1, T2 noch die Transistoren der Stromquellen I3, I4 in Sättigung gehen. Diese Funktion kann auch durch eine oder mehrere Dioden oder wie in Figur 2 durch einen Emitterfolger T9 bzw. T10 und eine oder mehrere zum Emitter in Reihe geschaltete Dioden D9 bzw. D10 erreicht werden.

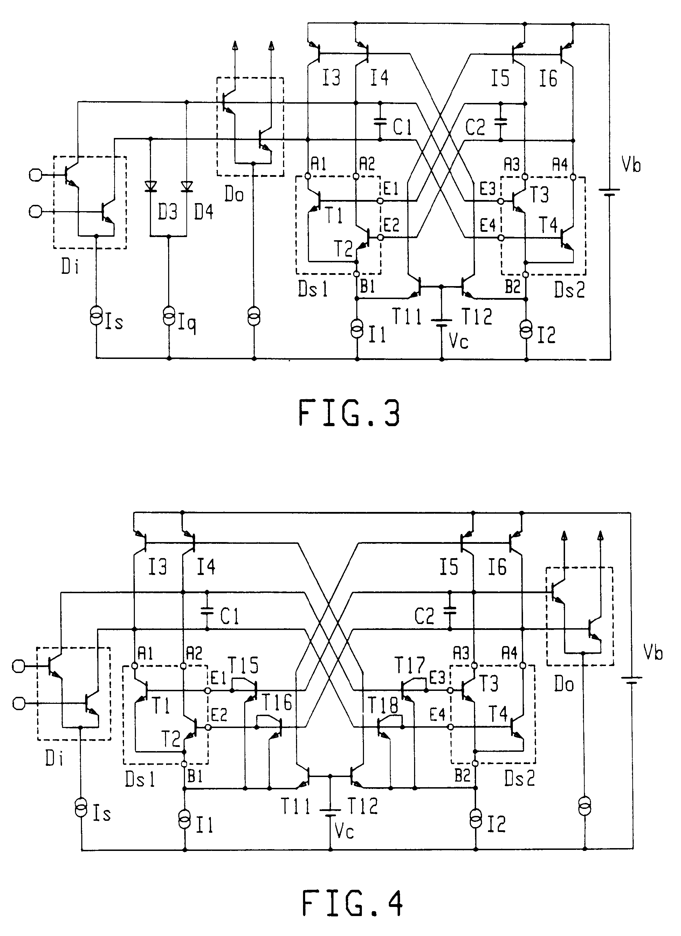

Eine andere Art des Koppelgliedes ist in Figur 3 und Figur 4 angegeben. Die Eingänge der Stromquellen I5, I6 sind mit dem Kollektor eines Transistors T11 verbunden. Der Emitter des Transistors T11 ist mit dem Einspeisepunkt der ersten Stromquelle I1 verbunden. Die Basis ist an einer Hilfsspannung Vc angeschlossen. Die Steuerung der Stromquellen I3, I4 in Figur 3 erfolgt mit Hilfe eines Transistors T12 sinngemäß spiegelbildlich.

Sind die von der Differenzstufe Ds1 abgegebenen Ströme untereinander ungleich, lädt die Differenz dieser Ströme den angeschlossenen Kondensator C1. Dadurch entsteht das Verhalten eines Integrierverstärkers. Dessen Zeitkonstante wird durch den Strom I1 beeinflußt. Bei Verwendung bipolarer Transistoren gilt für einen weiten Bereich des Stromes A1 = I1/(4*Ut*C1*p), wenn A1 der Zeiger der Spannungsverstärkung der Differenzstufe D1 ist, Ut die Temperaturspannung k*T/q und p der Frequenzoperator j*2*pi*f. Die zweite Differenzstufe Ds2 mit Stromquellen I2, I5, I6 und Abschlußkondensator C2 ist zur ersten gleichartig aufgebaut und mit ihr zu einer geschlossenen Verstarkerschleife zusammengefügt. Weil jedoch der Eingang E3 mit dem Ausgang A2 und der Eingang E4 mit dem Ausgang A1 verbunden wird, ist die Schleife statisch gegengekoppelt. Aus der Bedingung, daß die Eingangsspannung einer Differenzstufe jeweils die Ausgangsspannung der anderen ist, folgt die Eigenwertgleichung A1*A2 + 1 = 0, wobei A2 entsprechend die Verstärkung der Differenzstufe Ds2 ist. Dies ist die Form der Schwingungsgleichung. Die Schwingfrequenz ergibt sich daraus zu f = SQR(I1*I2/(C1*C2))/(8*pi*Ut). Wählt man I1 = I2 = I und C1 = C2 = C, dann ist die Schwingfrequenz f = I/(C*8*pi*Ut) proportional zum Strom der Stromquellen I1, I2.

Die Vorteile der beschriebenen Lösung bestehen in der Einfachheit des steuerbaren Integrierverstärkers, den geringstmöglichen Phasenfehlern, dem nur durch die aktiven Elemente selbst beschränkten Frequenzbereich und in der Anwendung erdfreier Kapazitäten, wobei keine Wechselströme über die Versorgungsquelle fließen.

Bedingt durch endliche Stromverstärkungen und durch Verluste zeigt die Schaltung normalerweise das Verhalten eines Resonanzkreises mit einer Güte in der Größenordnung um 30. Um sie in den Zustand der Oszillation zu bringen, ist vorgesehen, am Ausgang A1, A2 bzw. A3, A4 einer Differenzstufe Ds1 bzw. Ds2 eine Kreuzschaltung zweier Transistoren T13, T14 gemäß Figur 2 anzuschließen. Dazu wird der Kollektor des Transistors T13 mit der Basis des Transistors T14 und der Kollektor des Transistors T14 mit der Basis des Transistors T13 verbunden. Gleichzeitig ist jeder Kollektor mit je einer Ausgangsklemme verbunden. Die Emitter sind untereinander und mit einer Stromquelle Ir verbunden.

Durch die Kreuzschaltung wird an den Anschlußpunkten ein negativer Leitwert erzeugt, der zum Strom Ir proportional ist und die Schaltung entdämpft. Durch die Größe des Stromes Ir kann die Schwingung ausgelöst und die Schwingamplitude eingestellt werden, wobei man meist eine verzerrungsarme Oszillation mit minimalem Strom bevorzugen wird.

Das Signal kann an einem der Ausgänge A1, A2 bzw. A3, A4 einer Differenzstufe Ds1 bzw. Ds2 entnommen werden. Das geschieht z. B. mit einer weiteren Differenzstufe Do nach Figur 2, kann aber auch über Emitterfolger erfolgen.

Bei Anwendungen zur Selektion ist häufig eine weniger hohe Güte oder Resonanzschärfe erforderlich. Zu diesem Zweck ist gemäß Figur 3 eine Bedämpfung durch eine Reihenschaltung zweier Dioden D3, D4 vorgesehen, die am Anschlußpaar A1, A2 angeschaltet sind. Am Verbindungspunkt beider Dioden ist eine Stromquelle Iq oder stromantreibende Schaltung angeschlossen. Beide Dioden sind in Stromrichtung gepolt.

Unter der Wirkung des Stromes Iq entsteht zwischen den Anschlußpunkten A1, A2 ein positiver Leitwert, der zum Strom proportional ist und die Resonanz bedämpft. Durch die Größe des Stromes wird der Dämpfungsgrad eingestellt. Bei Variation der Resonanzfrequenz durch Variation der Ströme I1, I2 ist es erforderlich, den Strom Iq im gleichen Verhaltnis mit zu verändern, wenn die Kurve der Frequenzselektion unabhängig von der eingestellten Grenz- oder Mittenfrequenz sein soll. Der in die Anschlüsse A1, A2 einfließende, zusätzliche Strom Iq wird von den Stromquellen I3, I4 durch die Regelung über T12 zur Versorgungsquelle Vb weitergeleitet, ohne die Funktion der Schaltung zu beeinträchtigen.

Zur Einleitung eines Signales ist nach Figur 3 eine Differenzstufe Di vorgesehen, deren Ausgangsanschlüsse mit den Ausgangsanschlüssen A1, A2 der Differenzstufe Ds1 verbunden sind. Sie wird von einer Stromquelle Is versorgt. Bei Frequenzvariation durch Veränderung von I1, I2 muß auch Is im gleichen Verhältnis geändert werden, wenn die Verstärkung nicht von der eingestellten Frequenz abhängen soll.

In Figur 4 ist eine Tiefpaß-Schaltung dargestellt, bei der der Verbindungspunkt in der Reihenschaltung der Dämpfungsdioden mit dem Einspeisepunkt der Stromquelle I1 bzw. I2 an der Differenzstufe Ds1, Ds2 verbunden ist. Dadurch ist keine gesonderte Stromquelle Iq erforderlich. Die Dämpfungsdioden sind aus bipolaren Transistoren T15, T16, T17, T18 durch Verbindung des Kollektors mit der Basis gebildet. Die Dämpfungsdioden sind somit der Basis-Emitter-Diode der Transistoren der Differenzstufe parallelgeschaltet. Durch die Wahl des Flächenverhältnisses von Dämpfungsdiode zu Transistor der Differenzstufe Ds1 bzw. Ds2 kann in einer integrierten Schaltung die Dämpfung eingestellt werden. In der Schaltung nach Figur 4 ergibt sich z. B. ein Tiefpaß mit Butterworth-Charakteristik, wenn die Emitter-Basis-Sperrschicht der Dämpfungsdioden die 0,7-fache Fläche der Emitter-Basis-Sperrschicht der Transistoren der Differenzstufe aufweist.

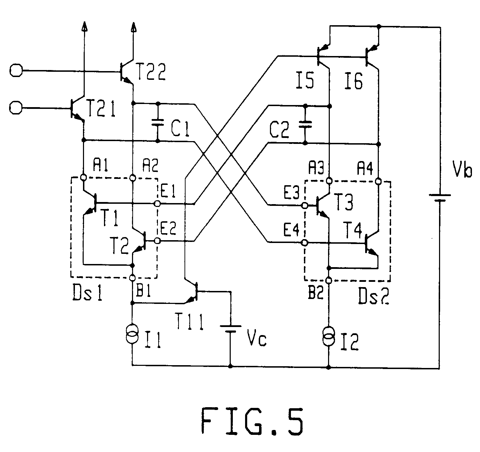

Das in Figur 5 dargestellte Anwendungsbeispiel zeigt eine Bandsperrenschaltung. Die Ausgänge A1, A2 der ersten Differenzstufe Ds1 sind mit je einem Emitter zweier Transistoren T21, T22 verbunden. Das Eingangssignal wird zwischen die Basen dieser Transistoren angelegt, das Ausgangssignal an den Kollektoren entnommen.

Die Transistoren T21 , T22 bilden eine Differenzstufe mit einer frequenzabhängigen Gegenkopplung. Die zwischen den Emittern wirksame Impedanz gleicht einem Parallelschwingkreis, so daß am Resonanzpunkt eine Sperrwirkung entsteht. Die Verbindung der Schaltung mit den Transistoren T21, T22 entlastet die Stromquellen I3, I4, so daß diese zusammen mit der Koppelschaltung T12 entfallen können.

## Patentansprüche

1. Schaltungsanordnung für einen abstimmbaren Verstärker oder Oszillator mit folgenden Merkmalen:
a) Es ist eine erste und zweite Differenzstufe (Ds1, Ds2) vorgesehen, die jeweils einen ersten und zweiten Eingang (E1, E2 bzw. E3, E4) sowie jeweils einen ersten und zweiten Ausgang (A1, A2 bzw. A3, A4) aufweisen,
b) es ist eine erste und zweite Stromquelle (I1, I2) mit jeweils einem Einspeisepunkt (B1, B2) vorgesehen, wobei die erste bzw. zweite Differenzstufe (Ds1 bzw. Ds2) von der ersten bzw. zweiten Stromquelle (I1 bzw. I2) gespeist wird,
c) der erste und zweite Ausgang (A1, A2 bzw. A3, A4) der ersten und zweiten Differenzstufe (Ds1, Ds2) sind jeweils über einen Kondensator (C1, C2) verbunden,
d) der erste und zweite Ausgang (A1, A2 bzw. A3, A4) der ersten bzw. zweiten Differenzstufe (Ds1 bzw. Ds2) sind mit je einem bipolaren Transistor (I3, I4 bzw. I5, I6) über dessen jeweiligen Kollektor als dritte und vierte bzw. fünfte und sechste Stromquelle verbunden, wobei deren Emittern eine Versorgungsspannung (Vb) zugeführt wird,
e) der erste und zweite Eingang (E1, E2 bzw. E3, E4) der ersten bzw. zweiten Differenzstufe (Ds1 bzw. Ds2) sind direkt mit dem ersten und zweiten Ausgang (A1, A2 bzw. A3, A4) der zweiten bzw. ersten Differenzstufe (Ds1 bzw. Ds2) verbunden und
f) die Basen der die fünfte und sechste bzw. die dritte und vierte Stromquelle bildenden Transistoren (I5, I6 bzw. I3, I4) sind über ein erstes bzw. zweites Koppelglied (T9 bzw. T10) mit dem Einspeisepunkt (B1, B2) der ersten bzw. zweiten Stromquelle (I1 bzw. I2) verbunden.

2. Schaltungsanordnung nach Anspruch 1, dadurch gekennzeichnet, daß die erste und zweite Differenzstufe (Ds1, Ds2) jeweils aus zwei bipolaren Transistoren (T1, T2 bzw. T3, T4) besteht, deren miteinander verbundene Emitter den Einspeisepunkt (B1, B2) der ersten bzw. zweiten Stromquelle (I1 bzw. I2) bilden, deren Basen den ersten und zweiten Eingang (E1, E2 bzw. E3, E4) und deren Kollektoren den ersten und zweiten Ausgang (A1, A2 bzw. A3, A4) bilden.

3. Schaltungsanordnung nach Anspruch 1 oder 2, dadurch gekennzeichnet, daß das erste und zweite Koppelglied aus je einer Diode oder einer Reihenschaltung von mehreren Dioden besteht.

4. Schaltungsanordnung nach Anspruch 1 oder 2, dadurch gekennzeichnet, daß das erste Koppelglied aus einem Transistor (T9) besteht, dessen Emitter mit den Basen der die fünfte und sechste Stromquelle bildenden Transistoren (I5, I6) verbunden ist, dessen Basis mit dem Einspeisepunkt (B1) der ersten Stromquelle (I1) und dessen Kollektor mit dem Bezugspunkt (M) verbunden ist und daß das zweite Koppelglied aus einem Transistor (T10) besteht, dessen Emitter mit den Basen der die dritte und vierte Stromquelle bildenden Transistoren (I3, I4) verbunden ist, dessen Basis mit dem Einspeisepunkt (B2) der zweiten Stromquelle (I2) und dessen Kollektor mit dem Bezugspunkt (M) verbunden ist.

5. Schaltungsanordnung nach Anspruch 4, dadurch gekennzeichnet, daß die Emitter der Transistoren (T9, T10) der Koppelglieder über wenigstens jeweils eine Diode (D9, D10) mit den Basen der die fünfte und sechste bzw. dritte und vierte Stromquelle bildenden Transistoren (I5, I6 bzw. I3, I4) verbunden sind.

6. Schaltungsanordnung nach Anspruch 1 oder 2, dadurch gekennzeichnet, daß das erste Koppelglied aus einem Transistor (T11) besteht, dessen Kollektor mit den Basen der die fünfte und sechste Stromquelle bildenden Transistoren (I5, I6) verbunden ist, dessen Basis an einer Hilfsspannung (Vc) angeschlossen ist und dessen Emitter mit dem Einspeisepunkt (B1) der ersten Stromquelle (I1) verbunden ist, und daß das zweite Koppelglied aus einem Transistor (T12) besteht, dessen Kollektor mit den Basen der die dritte und vierte Stromquelle bildenden Transistoren (I3, I4) verbunden ist, dessen Basis an der Hilfsspannung (Vc) angeschlossen ist und dessen Emitter mit dem Einspeisepunkt (B2) der zweiten Stromquelle (I2) verbunden ist.

7. Schaltungsanordnung für einen abstimmbaren Resonanzverstärker nach einem der Ansprüche 1 bis 6, dadurch gekennzeichnet, daß zur Beeinflussung oder Steuerung der Resonanzgüte, insbesondere zum Zwecke der Dämpfung, an den Ausgang (A1, A2 bzw. A3, A4) der ersten und/oder zweiten Differenzstufe (Ds1, Ds2) eine Reihenschaltung zweier Dioden (D3, D4) angeschlossen ist, deren Verbindungspunkt mit einer Stromquelle (Iq) oder stromleitenden Schaltung verbunden ist und wobei die Dioden (D3, D4) in Stromrichtung gepolt sind.

8. Schaltungsanordnung für einen abstimmbaren Resonanzverstärker nach Anspruch 7, dadurch gekennzeichnet, daß der Verbindungspunkt der Reihenschaltung der Dioden (T15, T16 bzw. T17, T18) mit dem Einspeisepunkt (B1) der ersten Stromquelle (I1) bzw. mit dem Einspeisepunkt (B2) der zweiten Stromquelle (I2) verbunden ist.

9. Schaltungsanordnung für einen abstimmbaren Oszillator nach einem der Ansprüche 1 bis 6, dadurch gekennzeichnet, daß zur Beeinflussung oder Steuerung der Resonanzgüte, insbesondere zum Zwecke der Anfachung, am Ausgang (A1, A2 bzw. A3, A4) der ersten und/oder zweiten Differenzstufe (Ds1 bzw. Ds2) eine Kreuzschaltung zweier Transistoren (T13, T14) angeschlossen ist, wobei jeder Ausgangsanschluß mit dem Kollektor des einen Transistors (T13 bzw. T14) und der Basis des anderen Transistors (T14 bzw. T13) verbunden ist und die beiden Emitter untereinander und mit einer Stromquelle (Ir) oder stromleitenden Schaltung verbunden sind.

10. Schaltungsanordnung für einen abstimmbaren Resonanzverstärker nach einem der Ansprüche 1 bis 8, dadurch gekennzeichnet, daß die Ausgangsanschlüsse (A1, A2 bzw. A3, A4) der ersten oder zweiten Differenzstufe (Ds1 oder Ds2) mit den Ausgangsanschlüssen einer weiteren Differenzstufe (Di) zum Zwecke der Signaleinleitung verbunden sind.

11. Schaltungsanordnung nach einem der Ansprüche 1 bis 10, dadurch gekennzeichnet, daß die Ausgangsanschlüsse (A1, A2 bzw. A3, A4) der ersten oder zweiten Differenzstufe (Ds1 oder Ds2) mit den Eingängen einer weiteren Differenzstufe (Do) zum Zwecke der Signalauskopplung verbunden sind.

12. Schaltungsanordnung für einen abstimmbaren Resonanzverstärker nach einem der Ansprüche 1 bis 6, dadurch gekennzeichnet, daß die Ausgänge (A1, A2 bzw. A3, A4) der ersten oder zweiten Differenzstufe (Ds1 oder Ds2) mit je einem Emitter zweier Transistoren (T21, T22) verbunden sind, wobei das Eingangssignal zwischen die Basen dieser Transistoren angelegt und das Ausgangssignal an den Kollektoren entnommen wird.

## Claims

1. Circuit arrangement for a tunable amplifier or oscillator having the following features:
a) there are provided a first and second differential stage (Ds1, Ds2) which each comprise a first and second input (E1, E2 or E3, E4) and also a first and second output (A1, A2 or A3, A4),
b) there are provided a first and second current source (I1, I2) each having a feed point (B1, B2), wherein the respective first or second differential stage (Ds1 or Ds2) is fed by the respective first or second current source (I1 or I2),
c) the first and second output (A1, A2 or A3, A4) of the first and second differential stage (Ds1, Ds2) are connected in each case by a respective capacitor (C1, C2),
d) the first and second output (A1, A2 or A3, A4) of the first and second differential stage (Ds1 and Ds2) are each connected, via its respective collector, to a respective bi-polar transistor (I3, I4 or I5, I6) which acts as a third and fourth or fifth and sixth current source, wherein a supply voltage (Vb) is supplied to the emitters,
e) the first and second input (E1, E2 or E3, E4) of the first and second differential stage (Ds1 or Ds2) are directly connected to the first and second output (A1, A2 or A3, A4) of the second and first differential stage (Ds1 or Ds2) respectively and
f) the bases of the transistors (I5, I6 or I3, I4) forming the fifth and sixth or the third and fourth current source are connected to the feed point (B1, B2) of the respective first and second current source (I1 and I2) via a respective first and second coupling member (T9 and T10).

2. Circuit arrangement in accordance with Claim 1, characterised in that, the first and second differential stage (Ds1, Ds2) each consist of two bi-polar transistors (T1, T2 or T3, T4) whose interconnected emitters form the feed point (B1, B2) of the respective first and second current source (I1 and I2), whose bases form the first and second input (E1, E2 or E3, E4) and whose collectors form the first and second output (A1, A2 or A3, A4).

3. Circuit arrangement in accordance with Claim 1 or 2, characterised in that, the first and second coupling member each consist of a diode or a series circuit comprising a plurality of diodes.

4. Circuit arrangement in accordance with Claim 1 or 2, characterised in that, the first coupling member consists of a transistor (T9) whose emitter is connected to the bases of the transistors (I5, I6) forming the fifth and sixth current source, whose base is connected to the feed point (B1) of the first current source (I1) and whose collector is connected to the reference point (M) and that the second coupling member consists of a transistor (T10) whose emitter is connected to the bases of the transistors (I3, I4) forming the third and fourth current source, whose base is connected to the feed point (B2) of the second current source (I2) and whose collector is connected to the reference point (M).

5. Circuit arrangement in accordance with Claim 4, characterised in that, the emitters of the transistors (T9, T10) of the coupling member are connected via at least a respective diode (D9, D10) to the bases of the transistors (I5, I6 or I3, I4) forming the fifth and sixth or third and fourth current source.

6. Circuit arrangement in accordance with Claim 1 or 2, characterised in that, the first coupling member consists of a transistor (T11) whose collector is connected to the bases of the transistors (I5, I6) forming the fifth and sixth current source, whose base is connected to an auxiliary voltage (Vc) and whose emitter is connected to the feed point (B1) of the first current source (I1) and that the second coupling member consists of a transistor (T12) whose collector is connected to the bases of the transistors (I3, I4) forming the third and fourth current source, whose base is connected to the auxiliary voltage (Vc) and whose emitter is connected to the feed point (B2) of the second current source (I2).

7. Circuit arrangement for a tunable tuned-amplifier in accordance with any of the Claims 1 to 6, characterised in that, for the purpose of affecting or controlling the resonance Q factor, in particular for the purpose of damping, a series circuit consisting of two diodes (D3, D4) is connected to the output (A1, A2 or A3, A4) of the first and/or second differential stage (Ds1, Ds2), the connecting point of the diodes being connected to a current source (Iq) or a current conducting circuit and wherein the diodes (D3, D4) are poled in the direction of the current.

8. Circuit arrangement for a tunable tuned-amplifier in accordance with Claim 7, characterised in that, the connecting point of the series circuit consisting of the diodes (T15, T16 or T17, T18) is connected to the respective feed point (B1) of the first current source (I1) or to the respective feed point (B2) of the second current source (I2).

9. Circuit arrangement for a tunable oscillator in accordance with any of the Claims 1 to 6, characterised in that, for the purpose of affecting or controlling the resonance Q factor, in particular for the purpose of excitation, a cross-coupled circuit consisting of two transistors (T13, T14) is connected to the output (A1, A2 or A3, A4) of the first and/or second differential stage (Ds1 or Ds2), whereby each output terminal is connected to the collector of the one transistor (T13 or T14) and to the base of the other transistor (T14 or T13) and the two emitters are connected to one another and to a current source (Ir) or a current conducting circuit.

10. Circuit arrangement for a tunable tuned-amplifier in accordance with any of the Claims 1 to 8, characterised in that, the output terminals (A1, A2 or A3, A4) of the first or second differential stage (Ds1 or Ds2) are connected to the output terminals of a further differential stage (Di) for the purpose of leading-in a signal.

11. Circuit arrangement in accordance with any of the Claims 1 to 10, characterised in that, the output terminals (A1, A2 or A3, A4) of the first or second differential stage (Ds1 or Ds2) are connected to the inputs of a further differential stage (Do) for the purpose of coupling-out a signal.

12. Circuit arrangement for a tunable tuned-amplifier in accordance with any of the Claims 1 to 6, characterised in that, the outputs (A1, A2 or A3, A4) of the first or second differential stage (Ds1 or Ds2) are each connected to a respective emitter of two transistors (T21, T22), whereby the input signal is applied between the bases of these transistors and the output signal is extracted at the collectors.

## Revendications

1. Montage pour un amplificateur ou un oscillateur accordable, ayant les particularités suivantes:
a) il comprend un premier et un deuxième étage différentiel (Ds1, Ds2) qui présentent chacun une première et une deuxième entrée (E1, E2; E3, E4) ainsi que, chacun, une première et une deuxième sortie (A1, A2; A3, A4),
b) il comprend une première et une deuxième source de courant (I1, I2), à chacune desquelles est coordonné un point d'alimentation (B1, B2), les premier et deuxième étages différentiels (Ds1; Ds2) étant alimentés respectivement par la première et la deuxième source de courant (I1; I2),
c) la première et la deuxième sortie (A1, A2; A3, A4) du premier et du deuxième étage différentiel (Ds1, Ds2) sont chaque fois reliées entre elles à travers un condensateur (C1, C2),
d) la première et la deuxième sortie (A1, A2; A3, A4) du premier et du deuxième étage différentiel (Ds1; Ds2) sont reliées chacune à un transistor bipolaire (I3, I4; I5, I6) à travers le collecteur correspondant de ce transistor, servant respectivement de troisième et quatrième source de courant, ainsi que de cinquième et sixième source de courant, avec application d'une tension d'alimentation (Vb) aux émetteurs de ces transistors,
e) les première et deuxième entrées (E1, E2; E3, E4) du premier et du deuxième étage différentiel (Ds1; Ds2) sont reliées directement aux première et deuxième sorties (A1, A2; A3, A4) du deuxième et du premier étage différentiel (Ds1; Ds2) respectivement et
f) les bases des transistors formant les cinquième et sixième sources de courant, respectivement les troisième et quatrième sources de courant (I5, I6; I3, I4), sont reliées à travers respectivement un premier et un second élément de couplage (T9; T10) au point d'alimentation (B1, B2) par la première et de la deuxième source de courant (I1; I2) respectivement.

2. Montage selon la revendication 1, caractérisé en ce que les premier et deuxième étages différentiels (Ds1, Ds2) sont formés chacun de deux transistors bipolaires (T1, T2; T3, T4) dont les émetteurs, reliés l'un à l'autre, forment le point d'alimentation (B1, B2) par la première et la deuxième source de courant (I1: I2) respectivement, dont les bases forment la première et la deuxième entrée (E1, E2; E3, E4) et dont les collecteurs forment la première et la deuxième sortie (A1, A2; A3, A4).

3. Montage selon la revendication 1 ou 2, caractérisé en ce que le premier et le second élément de couplage sont constitués chacun d'une diode ou d'un montage en série de plusieurs diodes.

4. Montage selon la revendication 1 ou 2, caractérisé en ce que le premier élément de couplage est constitué d'un transistor (T9) dont l'émetteur est relié aux bases des transistors formant les cinquième et sixième sources de courant (I5, I6), dont la base est reliée au point d'alimentation (B1) par la première source de courant (I1) et dont le collecteur est relié au point de référence (M), et que le second élément de couplage est constitué d'un transistor (T10) dont l'émetteur est relié aux bases des transistors formant la troisième et la quatrième source de courant (I3, I4), dont la base est reliée au point d'alimentation (B2) par la deuxième source de courant (I2) et dont le collecteur est relié au point de référence (M).

5. Montage selon la revendication 4, caractérisé en ce que les émetteurs des transistors (T9, T10) des éléments de couplage sont reliés à travers chaque fois une diode (D9, D10) au moins aux bases des transistors formant la cinquième et la sixième source de courant, respectivement la troisième et la quatrième source de courant (I5, I6; I3, I4).

6. Montage selon la revendication 1 ou 2, caractérisé en ce que le premier élément de couplage est constitué d'un transistor (T11) dont le collecteur est relié aux bases des transistors formant la cinquième et la sixième source de courant (I5, I6), dont la base est connectée à une tension auxiliaire (Vc) et dont l'émetteur est relié au point d'alimentation (B1) par la première source de courant (I1), et que le second élément de couplage est constitué d'un transistor (T12) dont le collecteur est relié aux bases des transistors formant la troisième et la quatrième source de courant (I3, I4), dont la base est connectée à la tension auxiliaire (Vc) et dont l'émetteur est relié au point d'alimentation (B2) par la seconde source de courant (I2).

7. Montage pour un amplificateur à résonance accordable selon une des revendications 1 à 6, caractérisé en ce que, pour influencer ou commander l'acuité de résonance, en particulier à des fins d'amortissement, le montage en série de deux diodes (D3, D4) est connecté à la sortie (A1, A2; A3, A4) du premier et/ou du deuxième étage différentiel (Ds1, Ds2), le point de connexion des diodes (D3, D4) entre elles étant relié à une source de courant (Iq) ou à un circuit conduisant le courant et les diodes (D3, D4) étant polarisées dans le sens du courant.

8. Montage pour un amplificateur à résonance accordable selon la revendication 7, caractérisé en ce que le point de connexion du montage en série des diodes (T15, T16; T17, T18) entre elles est relié au point d'alimentation (B1) par la première source de courant (I1) ou au point d'alimentation (B2) par la deuxième source de courant (I2).

9. Montage pour un oscillateur accordable selon une des revendications 1 à 6, caractérisé en ce que, pour influencer ou commander l'acuité de résonance, en particulier à des fins d'amorçage, le montage en croix de deux transistors (T13, T14) est raccordé à la sortie (A1, A2; A3, A4) du premier et/ou du deuxième étage différentiel (Ds1; Ds2), chaque borne de sortie étant reliée au collecteur d'un premier transistor (T13; T14) et à la base de l'autre transistor (T14; T13), et les deux émetteurs étant connectés entre eux et à une source de courant (Ir) ou un circuit conduisant le courant.

10. Montage pour un amplificateur à résonance accordable selon une des revendications 1 à 8, caractérisé en ce que les bornes de sortie (A1, A2; A3, A4) du premier ou du deuxième étage différentiel (Ds1 ou Ds2) sont reliées aux bornes de sortie d'un étage différentiel supplémentaire (Di) servant à l'introduction d'un signal.

11. Montage selon une des revendications 1 à 10, caractérisé en ce que les bornes de sortie (A1, A2; A3, A4) du premier ou du deuxième étage différentiel (Ds1 ou Ds2) sont reliées aux entrées d'un étage différentiel supplémentaire (Do) à des fins de découplage d'un signal.

12. Montage pour un amplificateur à résonance accordable selon une des revendications 1 à 6, caractérisé en ce que les sorties (A1, A2; A3, A4) du premier ou du deuxième étage différentiel (Ds1 ou Ds2) sont reliées chacune à un émetteur de deux transistors (T21, T22), le signal d'entrée étant appliqué entre les bases de ces transistors et le signal de sortie étant prélevé sur les collecteurs.
